# EUROPEAN PATENT SPECIFICATION

(11) **EP 2 713 393 B1**
(45) Date of publication and mention of the grant of the patent: **31.01.2018**
(21) Application number: 13186884.6
(22) Date of filing: 01.10.2013
(51) Int. Cl.: H01L 23/473

(54) **Dielectrophoretic cooling solution for electronics**
Dielektrophoretische Kühllösung für elektronische Vorrichtungen
Solution de refroidissement diélectrophorétique pour composants électroniques

(30) Priority: 01.10.2012 US 201213632332; 02.10.2012 US 201213633167
(43) Date of publication of application: 02.04.2014
(60) Divisional application: 16182440.4
(73) Proprietor: Hamilton Sundstrand Corporation, Windsor Locks, CT 06096-1010 (US)
(72) Inventor: Pearson, Matthew Robert, Hartford, CT 06103 (US); St.Rock, Brian, Andover, CT 06232 (US)
(74) Representative: Leckey, David Herbert

(56) References cited:
- WO-A1-2006/016293
- US-A1- 2008 101 022
- SHIMIN WANG ET AL: "Modeling dielectrophoretic force induced bubble motion in micro-channels", PROCEEDINGS OF THE ASME FLUIDS ENGINEERING DIVISION 2006 CONF - ASME FLUIDS ENGINEERING DIVISION 2006; 5-10 NOV. 2006; CHICAGO, IL, USA IN:; [FED // THE FLUIDS ENGINEERING DIVISION, ASME 0888-8116], ASME, US, vol. 262, 5 November 2006 (2006-11-05), pages 789-798, XP008172776, DOI: 10.1115/IMECE2006-16225 ISBN: 978-0-7918-4770-1

## Description

### BACKGROUND OF THE INVENTION

This application relates to the use of dielectrophoretic forces to cool electronic components.

The thermal management of electronics presents a large and growing challenge. High power density electronics result in an increase in the heat flux generated by electronic devices, such that passive cooling may no longer be sufficient. Thermal management limitations are beginning to present a ceiling from electronics reaching full capacity.

As an example, clock speeds on central processing units have been reduced, and the power rating for power electronic components has been restricted. The theoretical operating limits of the electronic devices far exceed what is possible to implement with present cooling solutions.

Fluid pumping has been proposed, however, most mechanical pumps raise reliability issues, and can introduce noise, vibration and other challenges.

Dielectrophoretic pumping is known, and has been proposed for some applications in cooling electronics. A dielectrophoretic force is generally provided by varying an electrical response relative to a bubble which is formed in a dielectric fluid. In general, the dielectric fluid in a liquid state behaves in one way relative to a dielectrophoretic force, but a bubble of vapor will react in a distinct manner.

US 2008/101022 discloses an electronic component and cooling system with the features of the preamble to claim 1. SHIMIN WANG ET AL: "Modeling dielectrophoretic force induced bubble motion in micro-channels" (Proceedings of the ASME Fluids Engineering Division 2006 Conf., ASME 0888-8116, vol. 262, 5 Nov. 2006, pages 789-798) and WO 2006/016293 disclose other electronic components and cooling systems.

### SUMMARY OF THE INVENTION

From one aspect, the present invention provides an electronic component and cooling system, in accordance with claim 1.

These and other features of this application will be best understood from the following specification and drawings, the following of which is a brief description.

### BRIEF DESCRIPTION OF THE DRAWINGS

Figure 1 shows an electronic stack arrangement outside the scope of the present invention.
Figure 2 is a cross-sectional view along line 2-2 of Figure 1.
Figure 3 shows an alternative arrangement outside the scope of the present invention.
Figure 4 shows an embodiment in accordance with the present invention.
Figure 5 shows another arrangement outside the scope of the present invention.

### DETAILED DESCRIPTION

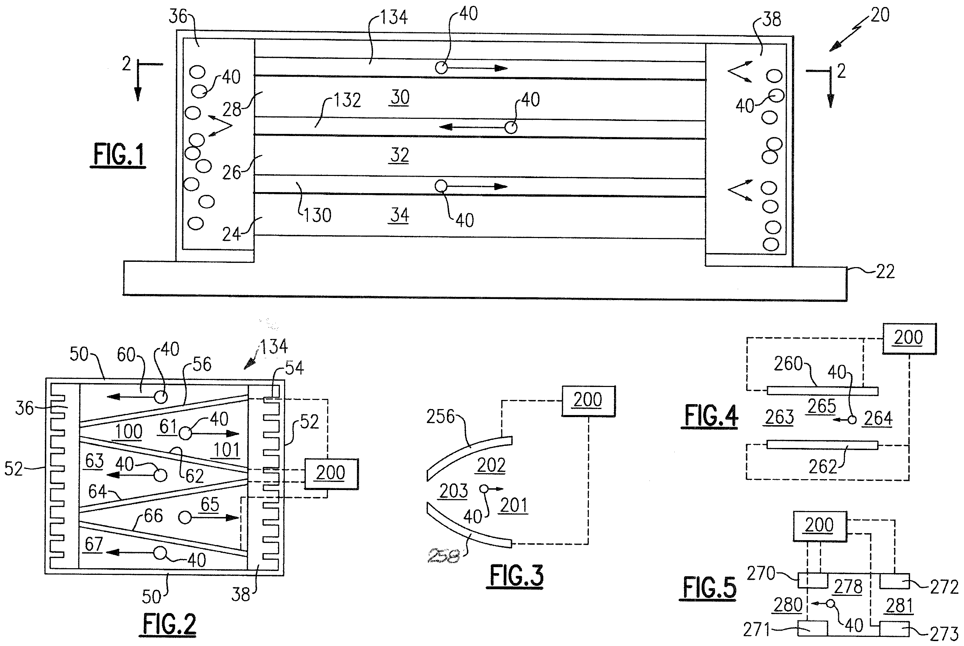

Figure 1 shows a stack 20 that mounts a plurality of electronic controls or cores 30, 32 and 34. On the other hand, this application would extend to a single cooling layer cooling a single control element. As disclosed, these may be electronic control elements, such as central processing units or power controllers, or any other component that requires cooling. The cores 30, 32, 34 are all generally planar.

Micro-channel cooling channels are defined at 130, 132 and 134, and intermediate the cores 30, 32, and 34. In a sense, the channels 130, 132, 134 and cores 30, 32, 34 are stacked in a direction generally perpendicular to the planar shape of the cores 30, 32, 34. Of course, the cores 30, 32, 34 are not actually planar.

End plenums 36 and 38 are defined at axial ends of the cooling channels 130, 132 and 134. A cold plate 22 is placed adjacent a lower most one of the cores 24, and operates to tap heat away. Another type heat sink can replace cold plate 22.

As shown in Figure 1, bubbles 40 may be formed in a cooling liquid which is received in the cooling passages 130, 132 and 134 and the plenums 36 and 38. A dielectric cooling fluid, as known, is utilized. When such fluids are heated, as they will from the heat generated by the cores 30, 32 and 34, bubbles 40 will form in the liquid.

As is clear from Figure 2, the cooling channels 130, 132, 134 as disclosed are actually formed of a plurality of sub-channels 60, 61, 63, 65, 67 aligned in a lateral direction, such that adjacent ones of the cooling sub-channels move bubbles in opposed directions. While plural sub-channels are disclosed, it is within the scope of this invention that a single channel be used.

As shown in Figure 2, one of the cooling channels 134 includes an internal electrode 56 defining a sub-channel 60 with one outer wall 50. The outer wall 50 either contains an electrode or acts as one. An internal sub-channel 61 is defined between electrodes 56 and 62. An internal sub-channel 63 is defined between electrodes 62 and 64. An internal sub-channel 65 is defined between electrodes 64 and 66, and a sub-channel 67 is defined between electrode 66 and another outer wall 50 that may contain an electrode, or act as one. The voltage applied to the walls/electrode 50 may differ from their paired electrodes 56 and 66 to create an electric field, as described below. As can be seen, the electrodes 56, 62, 64 and 66 extend in non-parallel directions relative to each other such that each of the sub-channels 60, 61, 63 and 65 and 57 decreases in flow cross-sectional area in one direction. A control/voltage source 200 applies an appropriate voltage to the electrodes.

Stated another way, cooling channels 130, 132 and 134 are provided with a plurality of electrodes, with adjacent ones of the electrodes extending in a non-parallel direction along an axial direction between the plenums 36 and 38. Adjacent electrodes (56 and 62 for example) extend in a direction with an axial component, and a lateral component, and with the lateral component from one adjacent electrode being opposed to a lateral component from a next adjacent electrode. Thus, a channel defined between adjacent electrodes increases in width from a smaller upstream end 100 to a larger downstream end 101, and such that when a different voltage potential is applied to adjacent electrodes, a dielectrophoretic force on a bubble 40 in the cooling channel 130, 132, 134 will force it towards the larger downstream end 101. Of course, each cooling channel 130, 132 and 134 as disclosed includes sub-channels 60, 61, 63, 65, and 67. At least some adjacent sub-channels (61, 63 and 65) are defined by a common electrode and each between another electrode. Lateral outer ones of the sub-channels 60 and 67 are defined by an electrode (56/66) and an axially extending outer wall 50, which either acts as or contains an electrode.

While the non-parallel electrodes are shown to be linear and straight in Figure 2, Figure 3 shows an arrangement, also outside the scope of the present invention, where the electrodes 256 and 258 extend to be non-parallel by being curved. In this manner, there is a greater electric field at an end 203 of the channel 202 than would exist at the end 201. This will result in the bubble being urged toward the end 201, as in the prior embodiment.

Electric voltage is provided across the electrodes 50, 56, 62, 64 and 66 from a control and power supply 200, shown schematically in Figure 2. When a voltage difference is provided between electrodes 56, 62, 64 and 66, and the electrodes in outer wall 50, then a dielectrophoretic force will be created tending to force bubbles 40 generated in each of the sub-channels in the direction where the electrodes are further spaced. Thus, in channels 60, 63 and 67, bubbles 40 move to the left in this figure, while channels 61 and 65 would have bubbles 40 moving to the right. Once the bubbles move into plenums 36 and 38, they move adjacent to the outer walls. Heat transfer fins 54 may be associated with outer walls 52 to assist in dissipating the bubbles, and draining heat outwardly through the outer walls 52 to the environment.

That is, due to the opposed lateral component of the adjacent electrodes, there is a smaller upstream end 100 and a larger downstream end 101. When a voltage difference is supplied between the electrodes 56 and 62, a force will be applied on any bubbles which will tend to force the bubbles toward the larger downstream end 101 where the electric field is weaker.

As a bubble moves outwardly beyond any of the sub-channels, more fluid will move inwardly into the opposed side of the sub-channels. That is, as a bubble 40 moves to the left of, for example, sub-channel 60, more fluid would flow in from the right hand side of the sub-channel 60, and from the plenum 38. Thus, there is constant movement of the fluid into and out of each of the sub-channels.

Figure 4 shows an embodiment in accordance with the present invention, wherein the electrodes 260 and 262 do extend parallel to each other. However, one or both of electrodes 260 and 262 are resistive electrodes, such that the voltage potential of the resistive electrode varies along its length, and the voltage difference between electrodes 260 and 262 at the downstream end 263 is less than at the upstream end 264 such that the electric field in the channel 265 at a downstream end 263 is less than the electric field an upstream end 264. Essentially, control/voltage source 200 applies a different voltage at downstream end 263 than at upstream end 264. The force varies smoothly between the two ends. In this manner, the bubble will be urged, as in the prior embodiment.

Figure 5 shows another arrangement, outside the scope of the present invention, wherein there are segmented electrodes 270 and 271 at a downstream end 280 of a channel 278. Other electrodes 272 and 273 are at the upstream end 281 of the channel 278. The electrodes 272 and 273 are supplied with a greater potential difference between them than the potential difference between electrodes 270 and 271 such that there will be a force urging a bubble in the downstream direction. Of course, more than two segments may be used.

The Figure 4 embodiment, similar to the Figures 1 and 2 arrangements, may also be utilized as single or multiple layers, and with multiple sub-channels or as a single channel.

In addition, the embodiment of Figure 4 would be utilized with plenums as in the arrangements of Figures 1 and 2.

As mentioned above, the cooling can be utilized for any number of electronic components. Thus, while CPUs are illustrated, other components such as IGBTs, MOSFETs, and any other power electronic component would also benefit from the teaching of this application.

In this manner, the stacked electronic control may be cooled adequately, without the requirement of complex structure.

Although an embodiment of this invention has been disclosed, a worker of ordinary skill in this art would recognize that certain modifications would come within the scope of this invention. For that reason, the following claims should be studied to determine the true scope and content of this invention.

## Claims

1. An electronic component and cooling system comprising;
at least one cooling channel (265) positioned adjacent to an electronic component, said at least one cooling channel (265) communicating with plenums (36,38) at each of two opposed axial ends;
a dielectric fluid received in said cooling channel (265); and
said cooling channel (265) being provided with at least two electrodes (260,262), and a voltage potential is applied to each of said at least two electrodes (260,262) so that an electric field is formed in said cooling channel (265) such that the electric field magnitude at the downstream end of said cooling channel (265) is less than an upstream electric field magnitude, and such that a dielectrophoretic force on a bubble in said cooling channel (265) will force it downstream; **characterised in that**
at least one of said at least one electrode (260,262) is an electrically resistive electrode such that its voltage potential varies along its length to create said downstream force.

2. The system as set forth in claim 1, wherein there are a plurality of electronic components (30,32,34), and a plurality of said at least one cooling channel (265).

3. The system as set forth in claim 2, wherein the plurality of electronic components (30, 32, 34) are a plurality of planar electronic controls (30,32,34) stacked in a direction perpendicular to their planar shape and the cooling channels (265) are positioned intermediate adjacent ones of said plurality of electronic controls (30, 32, 34).

4. The system as set forth in claim 1, 2 or 3, wherein said plurality of electrodes (260, 262) extend along a linear direction.

5. The system as set forth in any preceding claim, wherein said electronic controls (30,32,34) are central processing unit cores.

6. The system as set forth in any preceding claim, wherein heat transfer fins (54) are included in said plenums (36,38) adjacent outer walls (52) to assist in dissipation of heat from the dielectric liquid to the environment.

7. The system as set forth in any preceding claim, wherein there are a plurality of sub-channels in each of said cooling channels (265) defined by said plurality of electrodes (260, 262).

8. The system as set forth in claim 7, wherein there are laterally outer ones of said sub-channels defined by one of said electrodes (260, 262) and an axially extending outer wall (50).

## Patentansprüche

1. Elektronische Komponente und Kühlsystem umfassend,
zumindest einen Kühlkanal (265), der an eine elektronische Komponente angrenzend angeordnet ist, wobei der zumindest eine Kühlkanal (265) mit Lufträumen (36, 38) an jedem der beiden gegenüberliegenden axialen Enden kommuniziert;
eine dielektrische Flüssigkeit, die in dem Kühlkanal (265) empfangen wird; und
wobei der Kühlkanal (265) mit zumindest zwei Elektroden (260, 262) ausgestattet ist, und ein Spannungspotential an jeder von den beiden Elektroden (260, 262) angelegt ist, sodass ein elektrisches Feld in dem Kühlkanal (265) gebildet wird, sodass die elektrische Feldgröße am stromabwärtigen Ende des Kühlkanals (265) kleiner als eine stromaufwärtige elektrische Feldgröße ist, und sodass eine dielektrophoretische Kraft auf eine Blase in dem Kühlkanal (265) es stromabwärts zwingt;
**dadurch gekennzeichnet, dass**
zumindest eine von der zumindest einen Elektrode (260, 262) eine elektrisch resistive Elektrode ist, sodass ihr Spannungspotential entlang ihrer Lenge variiert, um die stromabwärtige Kraft zu bilden.

2. System nach Anspruch 1, wobei es eine Vielzahl von elektronischen Komponenten (30, 32, 34) und eine Vielzahl von dem zumindest einen Kühlkanal (265) gibt.

3. System nach Anspruch 2, wobei die Vielzahl von elektronischen Komponenten (30, 32, 34) eine Vielzahl von planaren elektronischen Steuerungen (30, 32, 34) ist, die in ein einer Richtung senkrecht zu ihrer planaren Form gestapelt ist, und die Kühlkanäle (265) zwischen angrenzenden einen der Vielzahl von elektronischen Steuerungen (30, 32, 34) angeordnet sind.

4. System nach Anspruch 1, 2 oder 3, wobei die Vielzahl von Elektroden (260, 262) sich entlang einer linearen Richtung erstreckt.

5. System nach einem der vorhergehenden Ansprüche, wobei die elektronischen Steuerungen (30, 32, 34) Zentralverarbeitungseinheitskerne sind.

6. System nach einem der vorhergehenden Ansprüche, wobei Wärmeübertragungsrippen (54) in den an die Außenwände (52) angrenzenden Lufträumen (36, 38) beinhaltet sind, um die Abgabe von Wärme von der dielektrischen Flüssigkeit an die Umwelt zu unterstützen.

7. System nach einem der vorhergehenden Ansprüche, wobei es eine Vielzahl von Unterkanälen in jedem von den Kühlkanälen (265) gibt, die durch die Vielzahl von Elektroden (260, 262) definiert ist.

8. System nach Anspruch 7, wobei es seitlich äußere von den Unterkanälen, die durch eine von den Elektroden (260, 262) definiert werden, und eine sich axial erstreckende Außenwand (50) gibt.

## Revendications

1. Système de refroidissement et à composants électroniques comprenant :
au moins un canal de refroidissement (265) positionné adjacent à un composant électronique, ledit au moins un canal de refroidissement (265) communiquant avec des plénums (36, 38) au niveau de chacune des deux extrémités axiales opposées ;
un fluide diélectrique reçu dans ledit canal de refroidissement (265) ; et
ledit canal de refroidissement (265) étant pourvu d'au moins deux électrodes (260, 262), et un potentiel de tension est appliqué à chacune desdites au moins deux électrodes (260, 262) de sorte à former un champ électrique dans ledit canal de refroidissement (265) tel que l'intensité du champ électrique au niveau de l'extrémité en aval dudit canal de refroidissement (265) est inférieure à une intensité du champ électrique en amont, et tel qu'une force diélectrophorétique sur une bulle dans ledit canal de refroidissement (265) la pousse vers l'aval ;
**caractérisé en ce que**
au moins une desdites au moins une électrode (260, 262) est une électrode électriquement résistive de sorte que son potentiel de tension varie sur sa longueur pour créer ladite force vers l'aval.

2. Système selon la revendication 1, comprenant une pluralité de composants électroniques (30, 32, 34), et une pluralité desdits au moins un canal de refroidissement (265).

3. Système selon la revendication 2, dans lequel la pluralité de composants électroniques (30, 32, 34) consistent en une pluralité de commandes électroniques planes (30, 32, 34) empilées dans une direction perpendiculaire à leur forme plane et les canaux de refroidissement (265) sont positionnés entre des commandes adjacentes parmi ladite pluralité de commandes électroniques (30, 32, 34).

4. Système selon la revendication 1, 2 ou 3, dans lequel ladite pluralité d'électrodes (260, 262) s'étendent le long d'une direction linéaire.

5. Système selon une quelconque revendication précédente, dans lequel lesdites commandes électroniques (30, 32, 34) consistent en des coeurs d'unités centrales de traitement.

6. Système selon une quelconque revendication précédente, dans lequel des ailettes de transfert de chaleur (54) sont incluses dans lesdits plénums (36, 38) de manière adjacente à des parois externes (52) pour aider à dissiper la chaleur du liquide diélectrique vers l'environnement.

7. Système selon une quelconque revendication précédente, dans lequel une pluralité de sous-canaux sont présents dans chacun desdits canaux de refroidissement (265) définis par ladite pluralité d'électrodes (260, 262).

8. Système selon la revendication 7, dans lequel des sous-canaux latéralement externes sont présents parmi lesdits sous-canaux définis par l'une desdites électrodes (260, 262) et une paroi externe s'étendant axialement (50).
